# EUROPEAN PATENT APPLICATION

(11) **EP 4 651 198 A1**
(43) Date of publication of application: **19.11.2025**
(21) Application number: 24175425.8
(22) Date of filing: 13.05.2024
(51) Int. Cl.: H01L 23/00

(54) **SILVER COATED COPPER RIBBON**

(71) Applicant: Heraeus Electronics GmbH & Co. KG, 63450 Hanau (DE)
(72) Inventor: Ditzel, Eckhard, 63450 Hanau (DE); Scharf, Juergen, 63450 Hanau (DE); Krüger, Frank, 63450 Hanau (DE); Kersting, Christian, 63450 Hanau (DE)
(74) Representative: Heraeus IP

(57) **Abstract**

The invention relates to a ribbon, preferably for bonding in power electronics, comprising a copper core with a surface and a coating layer superimposed over the surface of the copper core, wherein the coating layer comprises silver. The ribbon has in a cross-sectional area perpendicular to a longitudinal axis of the ribbon a height and a width perpendicular to the height, wherein the ratio of the height to the width is smaller than 0.8 and the height is in the range of 50 µm to 500 µm. The invention further relates to processes for making a ribbon, to a ribbon obtainable by said process, to an electronic assembly comprising at least two electronic elements and at least aforementioned ribbon, to a device comprising said electronic assembly and to a process of connecting two elements through afore mentioned ribbon by wedge-wedge-bonding.

## Description

The invention relates to a ribbon, preferably for bonding in power electronics, comprising a copper core with a surface and a coating layer superimposed over the surface of the copper core, wherein the coating layer comprises silver. The ribbon has in a cross-sectional area perpendicular to a longitudinal axis of the ribbon a height and a width perpendicular to the height, wherein the ratio of the height to the width is smaller than 0.8 and the height is in the range of 50 µm to 500 µm. The invention further relates to processes for making a ribbon, to a ribbon obtainable by said process, to an electronic assembly comprising at least two electronic elements and at least aforementioned ribbon, to a device comprising said electronic assembly and to a process of connecting two elements through afore mentioned ribbon by wedge-wedge-bonding.

Bonding wires and ribbons are electrical connecting elements in the field of assembly and connection technology for electronic modules. They are for example used in the manufacture of semiconductor devices for electrically interconnecting an integrated circuit and a printed circuit board during semiconductor device fabrication. Further, bonding wires and ribbons are used in power electronic applications to electrically connect transistors, diodes and the like with pads or pins of a housing. In the field of power electronics, thick bonding wires and ribbons are used for electrical connections in power modules. The high currents in this field require large cross-sections of the bonding wires and ribbons compared to cross-sections as found in thinner bonding wires in the field of microelectronics.

While bonding wires were made from gold in the beginning, nowadays less expensive materials are used such as copper or aluminium. Wires made of aluminium can be easily wedge-wedge-bonded applying only low forces, but their electrical conductivity is inferior compared to copper wires.

Wedge bonding is a method during which one end of the bonding wire or ribbon is pressed by using a wedge bonding tool onto the area to be bonded, typically a bond pad which provides a contact surface of an electronic module. By using a short ultrasonic pulse, an electrical connection between the bonding wire and the module carrying the bond pad is formed. Subsequently, the bonding tool may move from the first bonding point along with the bonding wire to a second bonding point on the contact surface. The bonding process is repeated here, whereby the bonding wire is additionally cut off.

Copper wires and ribbons provide very good electric and thermal conductivity, but wedge-bonding of such bonding items has its challenges compared to their counterparts made of aluminium. Moreover, copper wires and ribbons are susceptible to oxidation. To overcome this problem, development has been directed to bonding wires and ribbons having a core and a protective shell, which is, e.g., a coating layer. As core material, copper or gold may be chosen because of high electrical conductivity. With regard to the coating layer, aluminium has also been applied. These core-shell bonding wires and ribbons combine especially the high conductivity of copper with the advantageous bonding ability of aluminium. Aluminium coated copper wires are especially suitable for wedge-wedge-bonding applications. However, with the rise of new semiconductor materials, in particular WBG (wide bandgap) semiconductors like SiC and GaN, demanding higher operating temperatures than previous semiconductor generations over 200 °C, this material combination faces problems, in particular an accelerated migration between the different materials resulting in a shorter lifetime of the assembly. Thus, there is an ongoing need for further improving bonding wire and ribbon technology with regard to the bonding wire and/or ribbon itself and the bonding processes.

With respect to wire geometry, most common are bonding wires of circular cross-section and bonding ribbons which have a more or less rectangular or elliptical cross-section. Both types of wire geometries have their advantages making them useful for specific applications. Thus, both types of geometry have their share in the market. The larger, but also flatter, geometry of ribbon wires has a practical advantage in that the processing is more rapid since only a small number of ribbon wires, rather than many thinner bonding wires, need to be bonded to attain contacting. Thus, bonding ribbons have a larger contact area for a given cross-sectional area. Further, the flat geometry of ribbon wires allows lower loops to be generated. In addition, the heel damage at comparable loop geometry, i.e., the damage in the sensitive arc of the bonding material, is less pronounced than with comparable thick wires. This allows unusually high steps to be bridged by short bonds and thus to implement densely packed geometries in housing bonding.

Bonding wires and ribbons suitable to be used in a power device through which large currents flow such as a motor or the like, need to have a minimal diameter of at least 100 µm to withstand high temperatures and/or the high current densities of operation. Such wires and ribbons are typically bonded by wedge bonding to the respective substrate. This technique poses different challenges and requirements to the bonding wire in comparison to ball bonding, which is typically applied for thin wires with a diameter well below 100 µm. During wedge bonding, the bonding wire is heated and pressed with a certain force onto the contact pads of the electronic elements to be bonded, for example semiconductor substrates or housings. If the required force is too high, the surface of the substrate and especially the semiconductor can be damaged. Thus, it is desired to reduce the forces during the wedge bonding process while still ensuring a strong bond in order to minimize the risk to damage the semiconductor or the substrate surface.

Accordingly, it is an object of the invention to provide improved ribbons.

It is a further object of the invention to provide a ribbon which exhibits excellent bondability. Thus, it is an object to provide a ribbon which is in particular suitable for wedge bonding with a low bonding force. In the context of the present invention, a good wedge bondability is to be understood as the property of a bonding ribbon to obtain good performance in a bonding process with a low bonding force applied and at the same time a high bonding strength of the obtained wedge bond.

It is also an object of the invention to provide a ribbon which is suitable for operation temperatures over 200 °C, or even over 225 °C.

Another object of the invention is to provide a ribbon which has good processing properties, and which has no specific needs when interconnecting, thus saving costs.

It is also an object of the invention to provide a ribbon which has excellent electrical and thermal conductivity.

It is a further object of the invention to provide a ribbon which exhibits an improved reliability.

It is another object of the invention to provide a ribbon which has improved resistance to corrosion and/or oxidation.

It is another object to provide a novel ribbon to be used with standard bonding technology and especially suited for contacting WBG semiconductors, especially in wedge bonding applications, which assures extended lifetime over conventional wires.

It is a further object of the invention to provide means to enable smaller dimensions of electronic elements in electrical assemblies.

It is a further object to provide improved electronic assemblies, in particular for power electronics, which have an extended lifetime compared to conventional assemblies in which the electrical elements are interconnected by copper wires and/or ribbons or aluminium coated copper wires and/or ribbons.

It is another object to provide improved electronic assemblies, in particular for power electronics, which operate at higher electrical current flow than conventional assemblies in which bonding is provided by copper wires and/or ribbons or aluminium coated copper wires and/or ribbons.

It is another object of the invention to provide such improved electronic assemblies which have the same dimensions and similar semiconductor design as aforementioned conventional assemblies. It is another object to provide means for manufacturing such improved electrical assemblies on production lines originally designed for the manufacture of conventional electronic assemblies. This would minimize cost for implementing the improved technology.

Surprisingly, ribbons of the present invention have been found to solve at least one of the objects mentioned above. Further, a process for manufacturing these ribbons has been found which overcomes at least one of the challenges of manufacturing ribbons. Further, electronic assemblies comprising the ribbons of the invention were found to have a stronger bond connection and can withstand more temperature cycles and higher temperature differences be more reliable at the interface between the ribbons according to the invention and other electronic elements.

A contribution to the solution of at least one of the above objects is provided by the subject matters of the category-forming claims, whereby the dependent sub-claims of the category-forming independent claims representing preferred aspects of the invention, the subject matter of which likewise makes a contribution to solving at least one of the objects mentioned above.

A first aspect of the invention is a ribbon comprising:
(i) a copper core with a surface; and
(ii) a coating layer superimposed over the surface of the copper core,
wherein the coating layer comprises silver,
wherein the ribbon has in a cross-sectional area perpendicular to a longitudinal axis of the ribbon a height and a width perpendicular to the height, wherein the ratio of the height to the width is smaller than 0.8 and wherein the height is in the range of 50 µm to 500 µm.

The ribbon is preferably a bonding ribbon for bonding in power electronics. Preferably, the ribbon is a one-piece object. The criteria for aforementioned cross-sectional view, the width and the height should be met within at least 80 %, preferably 90 % of the longitudinal extension of the ribbon. It is to be understood, that if not referred to otherwise, the geometrical parameters are defined for a ribbon which is not bonded to an electronic element such as e.g. a semiconductor or a substrate.

The height of the ribbon is in the range of 50 µm to 500 µm, preferably in the range of 100 µm to 450 µm, or of 150 µm to 400 µm.

The height and the width of the ribbon may be defined as follows: The cross sectional area perpendicular to the longitudinal axis of the ribbon has a contour, a geometrical center, a height axis H, which runs through the geometrical center and intersects the contour in two points of intersection (P1, P2) on the shortest path. The height is the distance between the two points of intersection (P1, P2). The cross-sectional area further comprises a width axis W, which runs through the geometrical center and intersects the contour in two points of intersection (P3, P4) on the longest path, wherein the width axis W is perpendicular to the height axis H. The width is the distance between the two points of intersection (P3, P4).

Preferably, the width of the ribbon is in the range of 100 µm to 5,000 µm, preferably in the range of 500 µm to 4,500 µm, or of 800 µm to 4,000 µm.

The aspect ratio of the height to the width is smaller than 0.8, preferably smaller than 0.6, more preferred smaller than 0.5. For example, the ratio is in the range of from 0.03 to less than 0.8, preferably in the range of 0.05 to 0.6, more preferred in the range of 0.1 to 0.5. For example, a ribbon having a rectangular cross-section with dimensions of 1,000 µm × 600 µm has an aspect ratio of 0.6.

Preferred combinations of width and height of the ribbon are 500 µm × 50 µm, 1000 µm × 100 µm, 2000 µm × 200 µm, 2000 µm × 300 µm and 2000 µm × 400 µm.

In preferred embodiments, the ribbon has a cross-sectional area in the range of 25,000 µm² to 2 mm², preferably in the range of 35,000 µm² to 1,5 mm², more preferably in the range of 40,000 µm² to 1 mm².

The term "a cross-sectional view" in the present context refers to a view of a cut through the ribbon, wherein the plane of the cut is perpendicular to the longitudinal extension of the ribbon. The cross-sectional view can be found at any position on the longitudinal extension of the ribbon.

Preferably, the ribbon of the invention has a substantially rectangular or elliptical cross-sectional shape, preferably the cross-section has a rectangular shape. The ribbon may have rounded edges.

The copper core according to the invention preferably comprises at least 95 % by weight of elemental copper (Cu), preferably at least 98 % by weight, even more preferred at least 99 % by weight, most preferred less than 99.99 % by weight, each based on the total weight of the copper core.

Preferably, the copper core comprises less than 100 ppm further components, yet more preferred less than 50 ppm. In other words, the copper core preferably consists of copper and inevitable impurities. The low amount of these further components ensures good electrical properties of the ribbon. In the present context, the further components, often also referred as "inevitable impurities", are minor amounts of chemical elements and/or compounds which originate from impurities present in the raw materials used or from the manufacturing process which produced the ribbon. Examples of such further components are: Ni, Mn, Pt, Cr, Ca, La, Al, B, Zr, Ti, S, Fe. Further components present in the copper core are usually not added separately.

The "surface" of the copper core of an uncoated copper wire or ribbon is the wire/air interface.

The "surface" of the copper core of a coated, possibly annealed ribbon is defined to be the virtual limit of the copper core around its center, which virtual limit is where the concentration of Cu deviates more than 3 %-wt. from the concentration of Cu at the center of the core, which center is defined by the intersection of the width and the height as defined above.

The core of the ribbon is a homogeneous region of bulk material. Since any bulk material always has a surface region which might exhibit different properties to some extent, the properties of the core of the ribbon are understood as properties of the homogeneous region of bulk material. The surface of the bulk material region can differ in terms of morphology, composition (e.g. sulfur, chlorine and/or oxygen content) and other features. The surface is an interface region between the copper core and the coating layer superimposed on the copper core. Typically, the coating layer is completely superimposed on the copper core's surface. In the region of the ribbon between its core and the coating layer superimposed thereon a combination of materials of both, the core and the coating layer, can be present. This layer may also be referred to as the "intermediate layer".

The copper core has a width and a height, which may be defined as follows: The cross-sectional area perpendicular to the longitudinal axis of the copper core has a contour, a geometrical center, a height axis H, which runs through the geometrical center and intersects the contour in two points of intersection (P5, P6) on the shortest path. The height is the distance between the two points of intersection (P5, P6). The cross-sectional area further comprises a width axis W, which runs through the geometrical center and intersects the contour in two points of intersection (P7, P8) on the longest path, wherein the width axis W is perpendicular to the height axis H. The width is the distance between the two points of intersection (P7, P8).

Preferably, the width of the copper core is in the range of 90 µm to 4,990 µm, preferably in the range of 200 µm to 4,000 µm, or of 300 µm to 3,500 µm, each determined in a cross-sectional view of the copper core perpendicular to its longitudinal axis. Preferably, the height of the copper core is in the range of 40 µm to 450 µm, preferably in the range of 90 µm to 400 µm, or of 140 µm to 350 µm.

The ribbon comprises a coating layer, which comprises silver, superimposed over the surface of the copper core. The term "superimposed" in the context of this invention is used to describe the relative position of a first item, e.g. a copper core, with respect to a second item, e.g. a coating layer. Possibly, further items, such as an intermediate layer, may be arranged between the first and the second item. Preferably, the coating layer is at least partially superimposed over the surface of the copper core, e.g. for at least 30 %, 50 %, 70 % or for at least 90 % with respect to the total surface of the copper core.

Preferably, the coating layer completely envelops the surface of the copper core.

The coating layer comprising silver is preferably selected from the group consisting of silver, silver alloys or a combination of the two.

Preferably, the coating layer comprises at least 85 % by weight of elemental silver (Ag), preferably at least 90 % by weight, more preferred at least 95 % by weight, even more preferred at least 98 % by weight, each based on the total weight of the coating layer.

Preferably, the coating layer comprises less than 1000 ppm of further components, yet more preferred less than 500 ppm. The low amount of these further components ensures good electrical properties of the ribbon. In the present context, the further components, often also referred as "inevitable impurities", are minor amounts of chemical elements and/or compounds which originate from impurities present in the raw materials used or from the manufacturing process which produced the ribbon, in particular the raw materials used during the coating process. In other words, the coating layer preferably consists of silver and inevitable impurities. Examples of such further components are: Ni, Mn, Pt, Cr, Ca, La, Al, B, Zr, Ti, S, Fe. Further components present in the coating layer are usually not added separately.

According to another aspect of the invention, the thickness of the coating layer is in the range of 5 to 60 µm, preferably from 10 to 50 µm, preferably from 15 to 40 µm, or from 20 to 35 µm, each determined in a cross-sectional view of the ribbon. The aforementioned criteria for thickness of the coating layer should be met within at least 80 %, preferably 90 % of the longitudinal extension of the ribbon.

The term "thickness" in the context of this invention is used to define the size of a layer in perpendicular direction to the longitudinal axis of the ribbon, which layer is at least partially superimposed over the surface of the copper core.

All of aforementioned dimensions of length, e.g. width, height, thickness, diameter, longest path, shortest path are determined in a cross-sectional view as defined above.

Preferably, the thickness of the coating layer in a given cross-sectional area does not deviate around the copper core. In other words, the layer thickness has a substantially constant thickness in a given cross sectional area. For example, the thickness of the coating layer in a given cross-sectional area does not deviate by more than 5 %, preferably by not more than 3 %.

The coating layer has two "surfaces". The first "surface" of the coating layer is the ribbon/air interface. The second "surface" of the coating layer is defined to be the virtual limit of the coating layer defined by the concentration of Ag deviating more than 3 %-wt. from the concentration of Ag at the bulk region of coating layer. The bulk region is defined to be the region which is to be in equal distance between the first and the second "surface" of the coating layer.

According to another aspect of the invention, an intermediate layer is arranged between the copper core and the coating layer. The term "intermediate layer" in the context of this invention is a region of the ribbon, between the copper core and the coating layer. In this region, material as in the core as well as material as in the coating layer is present in combination, for example, in form of at least one intermetallic phase.

Due to diffusion phenomena, distinct borders between the copper core and the coating layer may disappear during the production (for example introduced by heat treatment steps) and/or storage of the ribbons. In particular, material from the copper core may diffuse into the material of the coating layer and material from the coating layer may diffuse into the material of the copper core. This may for example lead to the formation of alloys or intermetallic phases that are situated between the copper core and the coating layer. These alloys or intermetallic phases usually consist of elements that are present in the material of the copper core and in the material of the coating layer and usually comprise a gradient, whereby the content of the element of the material of the copper core decreases from the center of the ribbon towards the surface of the ribbon, and the content of the element of the material of the coating layer decreases from the surface or surface near regions of the ribbon towards the inside of the ribbon. Such diffusion phenomena may lead to the presence of an intermediate layer.

Preferably, the intermediate layer comprises only material of the copper core and material of the coating layer. According to a preferred aspect of the invention, the intermediate layer is arranged between the core and the coating layer, wherein the intermediate layer is adjacent to the copper core and adjacent to the coating layer. Such an intermediate layer enhances the adhesion between copper core and coating layer and ensures the functionality of the ribbon.

Preferably, the intermediate layer comprises less than 800 ppm further components, yet more preferred less than 500 ppm. In other words, the intermediate layer preferably consists of copper, silver and inevitable impurities.

In preferred embodiments, the intermediate layer of the ribbon is defined to be the region of the ribbon between the copper core and the coating layer in which the concentration of Cu deviates more than 3 %-wt. from the concentration of Cu in the copper core, based on the total weight of the copper core, and in which the concentration of Ag deviates more than 3 %- wt. from the concentration of Ag in the coating layer, based on the total weight of the coating layer.

In other words, the concentration of copper in the intermediate layer is preferably at least 3 %-wt. lower than the concentration of Cu in the copper core, and the concentration of silver in the intermediate layer is preferably at least 3 %-wt. lower than the concentration of Ag in the coating layer, based on the total weight of the coating layer.

Preferably, the intermediate layer does not comprise any materials and/or elements which are not present in the copper core or the coating layer.

The intermediate layer may comprise at least one intermetallic phase comprising material of the copper core and material of the coating layer.

Preferably, the intermediate layer comprises a concentration gradient of copper from the copper core towards the coating layer and a concentration gradient of silver from the coating layer towards the copper core in a direction perpendicular to the longitudinal axis of the ribbon. A concentration gradient is to be understood as a decrease in the concentration of the respective element. Such concentration gradients can further enhance the adhesion of the coating layer on the surface of the copper core, makes the production easier and raises the productivity of the ribbon.

According to another aspect of the invention, the thickness of the intermediate layer is in the range of 0.05 to 5 µm, preferably from 0.1 to 3 µm. The aforementioned criteria for thickness of the intermediate layer should be met within at least 80 %, preferably 90 % of the longitudinal extension of the ribbon. Sometimes, deviations in the thickness of the intermediate layer may occur due to imperfections of the intermediate layer, e.g. pores.

Preferably, the thickness of the intermediate layer in a given cross-sectional area does not deviate around the copper core. In other words, the thickness of the intermediate layer has a substantially constant thickness in a given cross sectional area. For example, the thickness of the intermediate layer in a given cross-sectional area does not deviate by more than 5 %, preferably by not more than 3 %.

Aforementioned dimensions, i.e. the thickness of the coating layer, the thickness of the intermediate layer, the width and height of the ribbon and of the copper core can be determined in a cross-sectional view of the ribbon, e.g. using light microscopy or scanning electron microscopy. In light microscopy, the copper core is colored in copper red, the coating layer is silvery and the intermediate layer is grey. The concentrations of copper and silver which were described above, can be determined using combined SEM/EDX (Scanning electron microscopy / energy dispersive X-ray spectroscopy).

A ribbon according to the invention may be manufactured by providing a ribbon precursor with a larger height and width than the inventive ribbon, comprising a copper core precursor and a silver coating layer precursor, and shaping the ribbon precursor to the final ribbon shape and/or dimensions.

The ribbon may alternatively be manufactured by providing a copper core precursor, reforming the copper core precursor to the final shape and/or dimensions of the copper core of the ribbon and coating the shaped copper core with a silver coating layer.

Preferably, the shaped and coated ribbon according to both alternatives is annealed in a further step.

Another aspect of the invention is a process for manufacturing a ribbon according to the invention, comprising at least the following steps:
I.) providing a ribbon precursor comprising a copper core precursor with a surface and a coating layer precursor, which coating layer precursor is superimposed over the surface of the copper core precursor, wherein the coating layer precursor comprises silver,
II.) shaping the ribbon precursor such that
   the ribbon obtains in a cross-sectional area perpendicular to a longitudinal axis of the ribbon a height and a width, wherein the width is perpendicular to the height,
   wherein the ratio of the height to the width is smaller than 0.8 and
   wherein the height is in the range of 50 µm to 500 µm.

Aspects of the invention directed to the ribbon described above are also preferred aspects of the ribbon obtained by aforementioned process for manufacturing a ribbon.

Precursor items are items of pre-stages, which have not reached the desired final dimensions of the final ribbon.

The copper core precursor according to the invention preferably comprises at least 95 % by weight of elemental copper (Cu), preferably at least 98 % by weight, even more preferred at least 99 % by weight, most preferred less than 99.99 % by weight, each based on the total weight of the copper core precursor.

Preferably, the copper core precursor comprises less than 100 ppm further components, yet more preferred less than 50 ppm. In other words, the copper core precursor preferably consists of copper and inevitable impurities. In the present context, the further components, often also referred as "inevitable impurities", are minor amounts of chemical elements and/or compounds which originate from impurities present in the raw materials used or from the manufacturing process which produced the ribbon. Examples of such further components are: Ni, Mn, Pt, Cr, Ca, La, Al, B, Zr, Ti, S, Fe. Further components present in the copper core precursor are usually not added separately.

The coating layer precursor, which is superimposed over the surface of the copper core precursor of the ribbon precursor, comprises silver. The coating layer precursor comprising silver is preferably selected from the group consisting of silver, silver alloys or a combination of the two.

Preferably, the coating layer precursor at least 85 % by weight of elemental silver (Ag), preferably at least 90 % by weight, more preferred at least 95 % by weight, even more preferred at least 98 % by weight, each based on the total weight of the coating layer precursor.

The cross-sectional area of the ribbon precursor may already have a ratio of the height to the width of smaller than 0.8, the cross-sectional area may also have a ratio above 0.8. The shape of the cross-sectional area is not further restricted, it may for example be substantially round, elliptical, or rectangular.

Preferably, the ribbon precursor has a width in the range of 0.3 to 5 mm, more preferred of 0.5 to 3 mm, or of 0.75 to 2 mm.

A ribbon precursor as in step I.) can be obtained by forming a silver coating layer precursor on at least part of the surface of a copper core precursor. Preferably the silver layer precursor is formed on 100 %, or from 80 to 100 %, or from 60 to 80 %, of the surface of the copper core precursor, each with respect to the total surface area of the copper core precursor. Numerous techniques for forming a silver layer on a copper surface are known. Preferred techniques are plating, such as electroplating and electroless plating, deposition of silver from the gas phase such as sputtering, ion plating, vacuum evaporation and chemical vapor deposition, and deposition of silver from a melt.

The ribbon precursor may also be obtained by a process during which a copper core precursor is enclosed in a silver jacket, the assembly may optionally be drawn to a desired diameter, width, height and/or shape and/or or annealed.

The silver coating layer precursor is preferably applied by electroplating. Silver electroplating is performed making use of a silver electroplating bath, i.e. an electroplating bath that allows for a copper cathode surface to be electroplated with silver. In other words, the silver electroplating bath is a composition allowing for direct application of silver in elemental, metallic form onto a copper surface wired as cathode.

Electroplating application of the silver coating layer precursor is performed by guiding a copper core precursor as a cathode through the silver electroplating bath. The so obtained silver-coated copper core precursor exiting the silver electroplating bath may be rinsed and dried. The use of water as a rinsing medium is expedient, with alcohol and alcohol/water mixtures being further examples of rinsing media. The silver electroplating of the copper core precursor passing through the silver electroplating bath can take place at a direct voltage in the range of, for example, 0.2 to 20 V at a current in the range of, for example, 0.001 to 5 A, in particular 0.001 to 1 A or 0.001 to 0.2 A. Typical contact times may be in the range of, for example, 0.1 to 120 seconds, preferably 5 to 60 seconds. The current densities used in this context can be in the range of, for example, 0.01 to 150 A/dm². The silver electroplating bath may have a temperature in the range of, for example, 25 to 50 °C, preferably 30 to 40 °C.

The thickness of the silver coating layer precursor can be adjusted as desired essentially via the following parameters: chemical composition of the silver electroplating bath, contact time of the copper core precursor with the silver electroplating bath, current density. In this context, the thickness of the silver layer precursor can generally be increased by increasing the concentration of the silver in the silver electroplating bath, by increasing the contact time of the copper core precursor employed as cathode and the silver electroplating bath, and by increasing the current density.

Pretreatment of the copper core precursor can be employed to adapt the surface roughness and/or to add a pattern to the surface of the copper core precursor. Numerous techniques are known to adapt the surface of the copper core precursor. Preferred techniques are cold roll forming, grinding and electrochemical grinding.

Shaping is preferably understood to mean a process in which a change in the shape of the work piece processed is attained without an attendant significant change in the mass of the work piece processed. A cutting process, for example, is not a shaping process, since the cutting process is associated with a reduction of the mass of the work piece processed by the mass of the severed part. Numerous techniques are known to shape the ribbon precursor in step II.). Preferred techniques are flat-rolling, die drawing or the like. In the latter case the precursor item is drawn in several process steps until the desired cross-sectional shape and/or dimensions are reached. Such wire die drawing processes are well known to the person skilled in the art. Conventional tungsten carbide and diamond drawing dies may be employed and conventional drawing lubricants may be employed to support the drawing.

According to an embodiment of the invention, shaping is conducted by means of flat-rolling. The rolling conditions are adapted suitably in this context such that the ribbon finally obtained has an aspect ratio of less than 0.8 after rolling.

According to another embodiment of the invention, shaping is conducted through drawing and/or extruding the ribbon precursor through a drawing die. For this purpose, drawing dies are provided first. These drawing dies have openings of a shape and cross-section that essentially correspond to the shape and cross-section to be provided to the bonding ribbons. Accordingly, the drawing dies preferably at least partly contain openings with an aspect ratio of no more than 0.8. However, the exact geometry of the openings of the drawing die is a function of the bonding ribbon materials that are used. Since the bonding ribbon may experience some increase in cross-section after being drawn due to the resilience of the bonding ribbon materials that are used, the openings in the drawing die may need to have a cross-section that is smaller than the desired cross-section of the bonding wire or ribbon. Lastly, the ribbon is drawn through the openings of the drawing die provided and thus takes on the shape of the openings of the drawing die.

Another aspect of the invention is an alternative process for manufacturing a ribbon according to the invention, comprising at least the following steps:
I.) providing a copper core precursor with a surface;
II.) shaping the copper core precursor, such that
   the copper core precursor obtains in a cross-sectional area perpendicular to a longitudinal axis of the ribbon a height and a width, wherein the width is perpendicular to the height,
   wherein the ratio of the height to the width is smaller than 0.8 and
   wherein the height is in the range of 40 µm to 450 µm.
III.) coating the surface of the shaped copper core with a coating layer comprising silver.

Aspects of the invention directed to the ribbon described above are also preferred aspects of the ribbon obtained by aforementioned process for manufacturing a ribbon.

The copper core precursor preferably comprises at least 95 % by weight, preferably at least 98 % by weight, each based on the total weight of the copper core, of elemental copper (Cu) of a purity of at least 99.9 % Cu. Preferably, the purity of the copper core is at least 99.99 %, or 99.999 %, or 99.9999 %.

Preferably, the copper core precursor comprises further components in the range of 0 to 100 ppm, yet more preferred less than 30 ppm. Examples of such further components are: Ni, Mn, Pt, Cr, Ca, La, Al, B, Zr, Ti, S, Fe. Further components present in the copper core are usually not added separately.

Preferably, the copper core precursor has a width in the range of 0.3 to 5 mm, more preferred of 0.5 to 3 mm, or of 0.75 to 2 mm.

The cross-sectional area of the copper core precursor may already have a ratio of the height to the width of smaller than 0.8, the cross-sectional area may also have a ratio above 0.8. The shape of the cross-sectional area is not further restricted, it may for example be substantially round, elliptical, or rectangular.

Preferably, the ribbon precursor has a width in the range of 0.3 to 5 mm, more preferred of 0.5 to 3 mm, or of 0.75 to 2 mm.

Shaping of the copper core precursor may be conducted as described above for the alternative process for manufacturing an inventive ribbon.

Coating of the shaped copper core precursor may be conducted as described for the alternative process for manufacturing an inventive ribbon herein.

Preferably, both aforementioned aspects of processes according to the invention may comprise a subsequent step in which the ribbon is annealed.

Numerous procedures are known in the art to anneal a wire, a wire precursor, a ribbon or a ribbon precursor, e.g. annealing can be performed in both, a continuous or in a discontinuous process, for example by a heat treatment in an oven or plasma annealing. In special applications, continuous and discontinuous processes may even be combined.

According to preferred embodiments of the invention, the annealing is performed by heating the ribbon to a temperature in the range from 140 to 400 °C, preferably from 160 to 350 °C, or from 200 to 300 °C, or from 220 to 280 °C and the temperature is maintained for 30 minutes to 5 hours, preferably from 30 minutes to 3 hours. Then, the ribbon obtained by annealing is cooled to room temperature. The cooling can be performed in various ways. One suitable way is to expose the wire or ribbon to ambient air at ambient temperature upon leaving the heating zone. The cooling of the ribbon to room temperature (T = 20 °C) according to aforementioned procedure can be usually achieved within 24 hours. A quenching of the ribbon should be avoided, e.g. by immersion in cold water and the like. Accordingly, another aspect is a process in which the cooling of the ribbon upon leaving the heating zone is not performed by quenching of the ribbon.

Preferably, the annealing is done dynamically while the ribbon or ribbon precursor is moved through an annealing furnace and wound onto a spool after having left the furnace. According to another aspect of the invention the annealing is performed in a continuous process, more preferably in a tube furnace.

The speed of the wire or ribbon during annealing in a tube furnace depends on the length of the tube of the tube furnace. As longer the tube, as higher speeds are feasible in order to obtain a certain exposure of energy to a piece of wire or ribbon. Preferred lengths of tubes of tube furnaces are in the range of 0.8 to 2.5 m, or from 1 to 2 m, or of 1.5 to 2.5 m.

The temperature in the tube of the furnace can be adjusted to the drawing or evaluated independently. Preferred temperatures in the tube are in the range of 150 to 600 °C, or from 200 to 600 °C, or from 250 to 550 °C. In general, the temperature is selected to be lower than the temperature at which at least one of the components or a mixture of at least two components present in the ribbon liquefies. For example, if partially soluble or insoluble two- or multi-components alloys are annealed, the eutectic temperature of the alloy should not be exceeded by the temperature in the oven.

According to another aspect of the invention, the temperature in the furnace is chosen to be at least 30 °C, or 50 °C, or 80 °C lower than the temperature at which at least one of the components or a mixture of at least two components of the ribbon liquefies.

According to another aspect of the invention the annealing speed is chosen in the range of 1 to 100 m/min, or from 5 to 30 m/min, or from 10 to 20 m/min.

According to another aspect of the invention, the annealing in the tube furnace may be performed in an inert atmosphere or a reducing atmosphere. This applies to both annealing in continuous as well as discontinuous processing. Numerous inert atmospheres as well as reducing atmospheres are known in the art. Of the known inert atmospheres, nitrogen is preferred. Of the known reducing atmospheres, hydrogen is preferred. Further, preferred reducing atmospheres are mixtures of nitrogen and hydrogen. Preferably, mixtures of nitrogen and hydrogen are preferred which are in the range of 90 to 98 %-Vol. nitrogen and of 10 to 2 Vol-% hydrogen, each referring to the total volume of the mixture. Preferred mixtures of nitrogen/hydrogen are equal to 90/10, 93/7, 95/5 and 97/3 Vol-%/Vol-%, each based on the total volume of the mixture. Applying reducing atmospheres in annealing is particularly preferred, if some parts of the surface of the ribbon are sensitive to oxidation by oxygen of the air, e.g. if copper of the ribbon is exposed to its surface.

According to another aspect of the invention, an intermediate layer is formed during annealing.

Another aspect of the invention is a ribbon obtainable by a as process defined above.

Another aspect of the invention is an electronic assembly comprising at least a ribbon according to the invention or a ribbon manufactured according to the invention.

Electronic assemblies shall be understood herein as electronic or power electronic subassemblies comprising at least one substrate (as circuit carrier), at least one semiconductor component (semiconductor) or, if applicable, at least one passive electronic component. Preferably, the electronic assembly is a power module.

Examples of substrates include IMS (insulated metal substrates), metal ceramic substrates, e.g. DCB substrates (direct copper-bonded substrates) or AMB substrates (active metal brazing substrates), PCBs (printed circuit boards), and leadframes.

Examples of semiconductor components include diodes, LEDs (light emitting diodes), dies (semiconductor chips), IGBTs (insulated-gate bipolar transistors), ICs (integrated circuits), and MOSFETs (metal-oxide-semiconductor field-effect transistors).

Preferably the electronic assembly comprises at least two electronic elements and the ribbon electronically connects the two electronic elements.

According to another aspect of the invention, at least one ribbon in the electronic assembly is connected to an electronic element of the electronic assembly by wedge-wedge bonding, preferably by ultrasonic or laser assisted wedge-wedge bonding.

Wedge bonding technology is known in the art and extensively described in the literature, e.g. in Shankara K. Prasad, "Advanced Wirebond Interconnection Technology", Kluwer Academic Publishers, 2004, ISBN 1-4020-7762-9, in particular chapter I (introduction) and chapter IV (process technology). During bond forming a certain force (typically measured in grams) is applied, supported by application of ultrasonic energy (typically measured in mA). The ribbon of the invention is in particular suitable for a bonding process with the application of relatively low bonding forces.

Another aspect of the invention is a process for manufacturing an electronic assembly comprising the steps of
I.) providing at least two electronic elements;
II.) providing a ribbon according to the invention or one of the embodiments thereto, or a ribbon obtained by a method according to the invention or one of the embodiments thereto;
III.) connecting the two electronic elements through the ribbon, wherein at least one of said connections is performed by wedge bonding.

Preferably, all connections are performed by wedge bonding.

In another preferred aspect of the invention, the electronic assembly comprises a first and a second bond pad and the ribbon is connected to the bond pads by wedge-wedge bonding.

Another aspect of the invention is a method for connecting an electronic assembly, comprising the steps of
I.) providing a ribbon according to the invention or one of the embodiments thereto, or a ribbon obtained by a method according to the invention or one of the embodiments thereto;
II.) providing an electronic assembly comprising a first bond pad and a second bond pad;
III.) bonding the ribbon provided in step I.) to the first bond pad of the electronic assembly by wedge bonding; and
IV.) bonding the ribbon of step I.) which is bonded to the first bond pad to the second bond pad of the electronic assembly by wedge bonding.

Preferably, step III.) and/or step IV.) are performed without the use of an inert gas or a forming gas. Forming gas is known in the art as a mixture of an inert gas like nitrogen with hydrogen, wherein the hydrogen content may provide for reduction reactions of oxidized ribbon material. In the sense of the invention, omitting of forming gas means that no reactive compounds like hydrogen is used.

Another aspect of the invention is the use of a ribbon according to the invention or of ribbon manufactured according to a process according to the invention in wedge-wedge bonding interconnections in an electronic assembly.

Another aspect of the invention is a device which comprises at least one electronic assembly as described above, preferably the device is an electronic vehicle, a solar cell or a wind turbine.

The following schematic drawings show aspects of the invention for improving the understanding of the invention in connection with some exemplary illustrations. It should be understood, however, that the invention is not limited to the precise arrangements and instrumentalities shown. The elements of the drawings are not necessarily to scale relative to each other. Like reference numerals designate corresponding similar parts. Herein
- Figure 1: shows a ribbon and a cross section of a ribbon;
- Figure 2: shows a cross-sectional view of a ribbon;
- Figure 3: shows a cross-sectional view of a ribbon comprising an intermediate layer;
- Figure 4: shows a process according to the invention;
- Figure 5: shows an alternative process for manufacturing a ribbon;
- Figure 6: shows an electronic assembly comprising two electronic elements and a ribbon;
- Figure 7: shows an electronic assembly comprising five electronic elements and four ribbons.

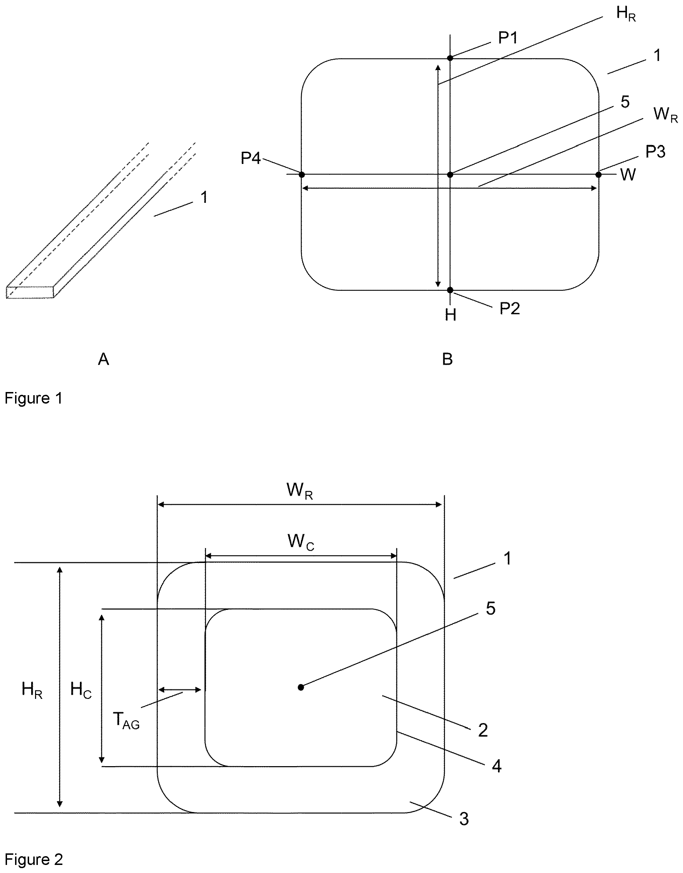

In Figure 1A, a ribbon 1 is depicted. Figure 1B shows a cross-sectional view of the ribbon 1 perpendicular to its longitudinal axis without an internal structure. The cross section can be characterized by the height H_{R}, which is the distance between two points of intersection P1 and P2 on the contour or the wire. The two points of intersection P1 and P2 are positioned on the height axis H, which extends through the geometrical center 5 of the ribbon and the two points of intersection P1 and P2 on the shortest path through the cross-section. The width of the ribbon W_{R} is the distance between two points of intersection P3 and P4 on the outer surface or the ribbon. The points P3 and P4 are positioned on a width axis W, which runs through the geometrical center 5 and intersects the contour in the two points of intersection (P3, P4) on the longest path. The width axis W is perpendicular to the height axis H.

Figure 2 shows a cross sectional view of a ribbon 1. The copper core 2 is encompassed by a coating layer 3 with a thickness T_{AG}. The surface 4 of the core is located on the limit of copper core 2. Besides, the width W_{R} and the height H_{R} of the ribbon as well as the width W_{C} and the height He of the copper core are depicted.

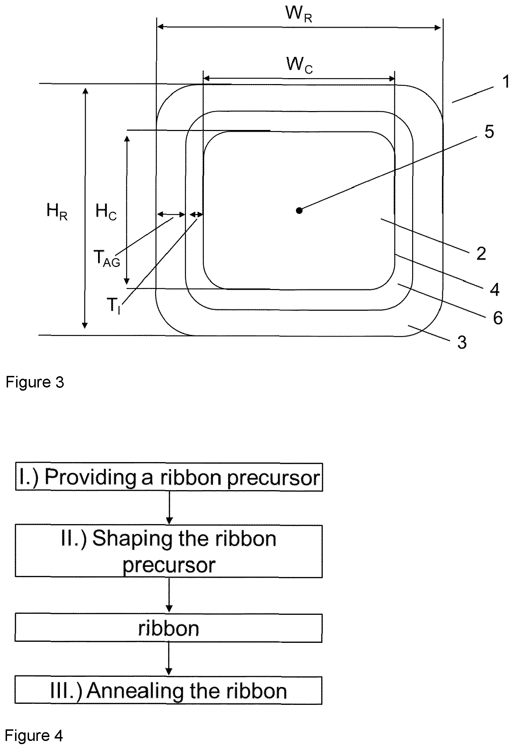

In Figure 3, a ribbon 1 having a copper core 2, an intermediate layer 6 and a coating layer 3 is depicted. In addition to the items described for Figure 2, the thickness T_{I} of the intermediate layer 6 is shown.

Figure 4 shows a process to manufacture a ribbon according to the invention.

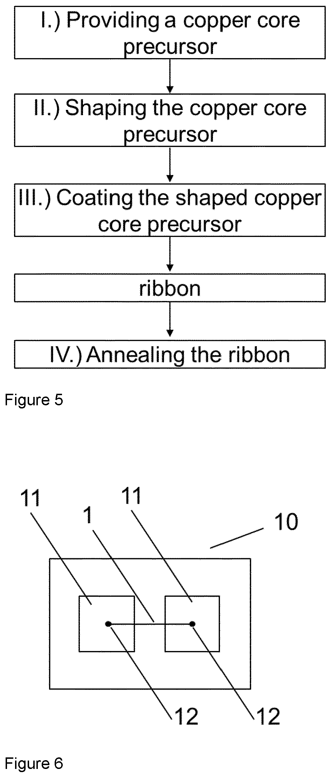

Figure 5 shows an alternative process to manufacture a ribbon according to the invention.

Figure 6 depicts an electronic module 10 comprising two electronic elements 11 and a ribbon 1. The ribbon 1 electrically connects the two electronic elements 11 via wedge bonds 12. One of the electronic elements 11 may be a semiconductor, which is connected via the bonding ribbon 1 to a substrate.

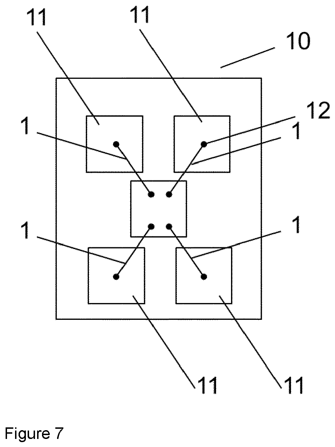

Figure 7 depicts another electronic module 10. Five electronic elements 11 are electrically connected by four ribbons 1. Only one of the eight wedge bonds 12 is assigned with a reference number for better clarity.

### Test Methods

All tests and measurements were conducted at T = 20 °C and a relative humidity of 50 %.

### Layer Thickness

For determining the thickness of the coating layer, the thickness of the intermediate layer and the diameter of the core, the ribbon was cut perpendicular to the maximum elongation of the ribbon. The cut was carefully grinded and polished to avoid smearing of soft materials, e.g. Ag. A picture was recorded through an optical microscope or a scanning electron microscope (SEM), wherein the magnification is chosen so that the full cross-section of the ribbon is shown.

This procedure was repeated at least 15 times. All values are provided as arithmetic mean of the at least 15 measurements.

The invention is further exemplified by a representative example. These example serves for exemplary elucidation of the invention and is not intended to limit the scope of the invention or the claims in any way.

A round copper wire with a diameter of 943 µm was deformed by rolling, resulting in a ribbon with a width of 2,000 µm and a height of 300 µm. The ribbon shaped copper was electroplated to obtain a silver coating with a thickness of 50 µm. Subsequently, the obtained ribbon was put on a metal spool and annealed in an oven for 1 hour at the annealing temperature 350 °C. After annealing, the ribbon was cooled to ambient temperature within 5 hours.

Relevant bonding parameters and characteristics of the inventive ribbon (Ag coated Cu ribbon) according to the example were compared with commonly used bonding ribbons with a width of 2,000 µm and a height of 300 µm (Al ribbon, Cu ribbon, Al coated Cu ribbon with an Al coating layer of 50 µm). The ribbons were wedge bonded on different substrates and the quality of the obtained bonds was evaluated. The temperature stability was tested by exposure of the bonded ribbon to the respective temperature and evaluating the time toto failure of the bond. Corrosion resistance was evaluated regarding the thermal stress resistance during use.

A qualitative comparison of the results is summarized in Table 1. Hereby

| | |
|---|---|
| ++ | indicates high suitability of performance or no/very late failure; |
| + | indicates general suitability of performance or late failure; |
| 0 | indicates average performance; |
| - | indicates low performance or early failure; |
| -- | indicates no suitability of performance or very early failure. |

**Table 1.**

| | Al ribbon | Cu ribbon | Al coated Cu ribbon | Ag coated Cu ribbon |
|---|---|---|---|---|
| Bonding on standard Si dies | ++ | -- | ++ | ++ |
| Temperature stability ≤ 150°C | ++ | ++ | ++ | ++ |
| Temperature stability ≤ 175°C | ○ | ++ | ++ | ++ |
| Temperature stability ≤ 200°C | -- | ++ | ○ | ++ |
| Corrosion resistance | ○ | + | ○ | ++ |

The performance parameters of the Ag coated Cu ribbon would in general be comparable to a pure Ag ribbon, but the costs are significantly lower.

### Reference Signs

- (1): ribbon
- (2): copper core
- (3): coating layer
- (4): surface of copper core
- (5): geometrical center of copper core
- (6): intermediate layer
- (10): electronic assembly
- (11): electronic element
- (12): wedge bond
- W_{R}: Width of ribbon
- H_{R}: Height of ribbon
- W_{C}: Width of copper core
- He: Height of copper core
- T_{AG}: Thickness of silver coating
- T_{I}: Thickness of intermediate layer
- H: Height axis
- W: Width axis
- P1, P2, P3, P4: Points of intersection

## Claims

1. A ribbon comprising:
(i) a copper core with a surface; and
(ii) a coating layer superimposed over the surface of the copper core, wherein the coating layer comprises silver,
wherein the ribbon has in a cross-sectional area perpendicular to a longitudinal axis of the ribbon a height and a width perpendicular to the height,
wherein the ratio of the height to the width is smaller than 0.8 and
wherein the height is in the range of 50 µm to 500 µm.

2. A ribbon according to claim 1, wherein the cross-sectional area is in the range of 25,000 µm² to 2 mm².

3. A ribbon according to claim 1 or 2, wherein the ribbon has a substantially rectangular or elliptical cross-sectional shape.

4. A ribbon according to any of the preceding claims, wherein the copper core comprises at least 95 % by weight of elemental copper (Cu), based on the total weight of the copper core.

5. A ribbon according to any of the preceding claims, wherein the copper core comprises less than 100 ppm of further components.

6. A ribbon according to any of the preceding claims, wherein the height of the copper core is in the range of 40 µm to 450 µm.

7. A ribbon according to any of the preceding claims, wherein the coating layer comprises at least 85 % by weight of elemental silver (Ag), based on the total weight of the coating layer.

8. A ribbon according to any of the preceding claims, wherein the thickness of the coating layer is in the range of 5 to 60 µm.

9. A ribbon according to any of the preceding claims, wherein an intermediate layer is arranged between the copper core and the coating layer.

10. A ribbon according to claim 9, wherein the intermediate layer comprises only material of the copper core and material of the coating layer.

11. A process for manufacturing a ribbon according to claims 1 - 10, comprising at least the following steps:
I.) providing a ribbon precursor comprising a copper core with a surface and a coating layer, which coating layer is superimposed over the surface of the copper core, wherein the coating layer comprises silver;
II.) shaping the ribbon precursor such that
the ribbon obtains in a cross-sectional area perpendicular to a longitudinal axis of the ribbon a height and a width, wherein the width is perpendicular to the height,
wherein the ratio of the height to the width is smaller than 0.8 and
wherein the height is in the range of 50 µm to 500 µm.

12. A process for manufacturing a ribbon according to claims 1 - 10, comprising at least the following steps:
I.) providing a copper core precursor with a surface;
II.) shaping the copper core precursor, such that
the copper core precursor obtains in a cross-sectional area perpendicular to a longitudinal axis of the copper core precursor a height and a width, wherein the width is perpendicular to the height,
wherein the ratio of the height to the width is smaller than 0.8 and
wherein the height is in the range of 40 µm to 450 µm.
III.) coating the surface of the shaped copper core with a coating layer comprising silver.

13. An electronic assembly comprising at least a ribbon according to any of claims 1 - 10 or a ribbon manufactured according to claim 11 or 12.

14. An electronic assembly according to claim 13, wherein the ribbon is bonded by wedge-wedge bonding.

15. A process for manufacturing an electronic assembly comprising the steps of
I.) providing at least two electronic elements;
II.) providing a ribbon according to any of claims 1 - 10 or obtained by a method according to claim 11 or 12;
III.) connecting the two electronic elements through the ribbon, wherein at least one of said connections is performed by wedge bonding.
